(19) Europäisches Patentamt
European Patent Office
Office européen des brevets

(11) EP 1 635 452 B1

(12) **EUROPÄISCHE PATENTSCHRIFT**

(45) Veröffentlichungstag und Bekanntmachung des Hinweises auf die Patenterteilung:
**31.10.2012 Patentblatt 2012/44**

(51) Int Cl.:
*H03D 9/06* (2006.01)     *G01J 9/00* (2006.01)
*H01L 27/146* (2006.01)

(21) Anmeldenummer: 05108315.2

(22) Anmeldetag: **09.09.2005**

(54) **Vorrichtung zur Laufzeit-sensitiven Messung eines Signals**

Apparatus for delay-sensitive measurement of a signal

Dispositif pour le mesurage sensitif au temps de transit d'un signal

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **13.09.2004 DE 102004044581**

(43) Veröffentlichungstag der Anmeldung:
**15.03.2006 Patentblatt 2006/11**

(73) Patentinhaber: **PMDTechnologies GmbH 57076 Siegen (DE)**

(72) Erfinder:
• **Gollewski, Torsten**
  **85101 Lenting (DE)**
• **Lange, Robert, Dr.**
  **57368 Lennestadt (DE)**
• **Ringbeck, Thorsten, Dr.**
  **57076 Siegen (DE)**
• **Heß, Holger**
  **57076 Siegen (DE)**
• **Buxbaum, Bernd, Dr.**
  **56457 Westerburg (DE)**

(74) Vertreter: **Weber, Roland et al WSL Patentanwälte Kaiser-Friedrich-Ring 98 65185 Wiesbaden (DE)**

(56) Entgegenhaltungen:
WO-A-02/14814          DE-A1- 19 902 612
US-A1- 2004 012 834     US-A1- 2004 051 926

• **HEINOL H G ET AL: "PHOTOMISCHDETEKTOR ERFASST 3D-BILDER NEUES OPTISCHES BAUELEMENT VEREINIGT DETEKTION UND MISCHUNG" ELEKTRONIK, WEKA FACHZEITSCHRIFTENVERLAG, POING, DE, Bd. 48, Nr. 12, 15. Juni 1999 (1999-06-15), Seite 80,82,84,86,88,90, XP000913168 ISSN: 0013-5658**

EP 1 635 452 B1

## EP 1 635 452 B1

**Beschreibung**

Die vorliegende Anmeldung betrifft eine Vorrichtung zur Erfassung der Phasenlage eines intensitätsmodulierten Signals.

Aus dem Stand der Technik sind Phasen- bzw. Laufzeit-sensitive Mischdetektorelemente zur Abstandsmessung bekannt. Solche Elemente sind beispielsweise in den deutschen Patentanmeldungen DE 196 35 932 und DE 197 04 496 als sogenannte Photogate Photomixing-Devices (PG-PMD) für elektromagnetische Strahlung beschrieben. Alternativ zu den PG-PMD-Elementen können die Mischdetektorelemente beispielsweise auch als MSM-PMD-Elemente (MSM: Metall-Halbleiter-Metall, von engl. Metall-Semiconductor-Metall) ausgestaltet sein, so wie sie in der WO 02/33922 A2 offenbart sind.

Gemeinsam ist den aus dem Stand der Technik bekannten Mischdetektorelementen, daß sie Ausleseelektroden aufweisen, zwischen denen sich ein photoleitfähiges Material, insbesondere ein Halbleitermaterial, erstreckt. Zusätzlich können auf dem Halbleitermaterial zwei oder mehrere transparente Modulationsgates vorgesehen sein.

Wird der photoleitfähige Teil des Detektorelements mit intensitätsmodulierter elektromagnetischer Strahlung, vorzugsweise im sichtbaren oder infraroten Spektralbereich, beleuchtet, so ändert sich die Leitfähigkeit des Detektorelements zwischen den Ausleseelektroden in Abhängigkeit von der momentan auf den Detektor einfallenden Intensität. Werden gleichzeitig an die Modulationsgates (bei PG-PMD-Elementen) oder auch direkt an die Ausleseelektroden (bei MSM-PMD-Elementen) amplitudenmodulierte Strom- oder Spannungssignale angelegt, welche zueinander invertiert oder um 180° phasenverschoben sind, so erhält man an den Ausleseelektroden Mischsignale, welche mit der Differenzfrequenz zwischen der Frequenz der Intensitätsmodulation der einfallenden Strahlung und der Referenzfrequenz moduliert sind. Die Ausgangssignale an den Ausleseelektroden der MIscherelemente sind zudem von der Intensität der einfallenden Strahlung abhängig. Bildet man nun die Summe der beiden Ausgangssignale der Ausleseelektroden, so erhält man ein von der Intensität der einfallenden Strahlung abhängiges Signal, indem lediglich die Gleichanteile (DC) enthalten sind. Demgegenüber enthält das Differenzsignal zwischen den beiden Ausgangssignalen der Ausleseelektroden lediglich die korrelierten Signalanteile. Das Differenzsignal trägt daher weiterhin sowohl die Phasen- als auch die Amplitudeninformation der einfallenden intensitätsmodulierten Strahlung. Das beschriebene Verfahren wird auch als Gegentaktdetektion oder "Balanced Detection" bezeichnet, da die Modulations- bzw. Ausleseelektroden des Mischerelements mit zueinander invertierten bzw. um 180° phasenverschobenen Signalen beschaltet sind. Das Gegentaktverfahren erlaubt es, durch Bildung der Differenz zwischen den beiden Ausgangssignalen des Mischdetektors, wie zuvor beschrieben, die Gleichanteile und die Asymmetrien der Mischerstruktur zu unterdrücken und nur solche Signale zu berücksichtigen, welche korreliert sind.

Da bei den Messungen Amplitude und Phase des Signals unbekannte Größen sind, sind in Abhängigkeit vom Modulationssignal der auf den Mischer einfallenden Strahlung und des Referenzsignals mindestens zwei Messungen mit verschiedener Phasenlage der Referenzsignale notwendig, um Amplitude und Phase des Meßsignals nach der Differenzbildung zu bestimmen.

Bei den aus dem Stand der Technik bekannten Detektoren werden die beiden Messungen entweder mit Hilfe eines Raummultiplex-Verfahrens oder mit Hilfe eines Zeitmultiplex-Verfahrens durchgeführt.

Beim Raummultiplex-Verfahren weist ein Detektor oder Bildpunkt zwei Mischdetektoren auf. Dabei können die beiden Mischdetektorelemente entweder diskret nebeneinander angeordnet oder auch ein integriertes Bauelement sein, z.B. mit paarweise über Kreuz angeordneten Ausleseelektroden, bilden. Entscheidend ist, daß die Referenzsignale eines jeden Detektorelements im Gegentakt moduliert sind, während sie zu den Referenzsignalen des zweiten Detektorelements jeweils, idealerweise um 90°, phasenverschoben sind. Auf diese Weise lassen sich zwei Korrelationsfunktionen des zu messenden Signals bestimmen und Phase und Amplitude können ausgewertet werden. Beim Raummultiplex wird für jeden Bildpunkt etwa die doppelte Fläche eines einzelnen Mischerelements benötigt, um gleichzeitig zwei Autokorrelationsfunktionen auswerten zu können.

Beim Zeitmultiplex werden die beiden Autokorrelationsfunktionen des Signals zeitlich nacheinander bestimmt, wobei zwischen zwei zusammengehörenden Messungen die Referenzsignale des Mischdetektorelements relativ zueinander phasenverschoben werden. Das Zeitmultiplex-Verfahren nimmt daher doppelt so viel Meßzeit in Anspruch wie das Raummultiplexverfahren. Dies ist insbesondere für Anwendungen nachteilig, bei denen die Meßzeit eine erheblich Rolle spielt. Sollen beispielsweise Abstände im Straßenverkehr erfaßt werden, so sind kurze Meßzeiten essentiell, um einem Fahrers oder auch einem autonomen Systems ausreichend Reaktionszeit beispielsweise zum Ausweichen um ein Hindernis zur Verfügung zu stellen.

Die deutsche Offenlegungsschrift DE 199 02 612 A1 offenbart einen optoelektronischen Mischer zur Demodulation eines mit einer Signalfrequenz hochfrequentamplitudenmodulierten Lichtsignals, der einen das Lichtsignal in freie Ladungsträger umwandelnden Lichtsensor und einen mit dem Lichtsensor verbundenen Referenzfrequenzgenerator zum Anlegen einer Wechselspannung mit einer Referenzfrequenz den Lichtsensor aufweist. Dabei weist der Lichtsensor mindestens zwei individuell ansteuerbare Sensorelektroden auf, wobei der Referenzfreauenzgenerator mit beiden Sensorelektroden verbunden ist, um die im Takt der Signalfrequenz vom Lichtsignal erzeugten Ladungsträger im Takt der Referenzfrequenz abwechselnd zu der einen Sensorelektrode oder zu der anderen Sensorelektrode zu leiten. Auch der in diesem Dokument offenbarte Mischer erfordert ein Raummultiplex-Verfahren oder ein Zeitmultiplex-Verfahren zur Messung von Phase und Amplitude des amplitudenmodulierten Lichtsignals.

Demgegenüber liegt der vorliegenden Erfindung die Aufgabe zugrunde, eine Vorrichtung bereitzustellen, die es ermöglichen, die vorgenannten Nachteile des Standes der Technik zu vermeiden.

Diese Aufgabe wird erfindungsgemäß durch eine Vorrichtung gemäß Anspruch 1 gelöst.

Dabei ist das "intensitätsmodulierte Signal" ein elektromagnetisches Signal, vorzugsweise im sichtbaren oder infraroten Spektralbereich.

Die Referenzsignale können elektrische oder elektromagnetische Signale, aber auch Ultraschallsignale sein.

Das Prinzip der vorliegenden Erfindung beruht darauf, daß das Mischsignal zwischen dem intensitätsmodulierten Signal und dem ersten Referenzsignal, welches die Amplituden- und Phaseninformation des intensitätsmodulierten Signals trägt, mit einem zweiten und einem dritten Referenzsignal bekannter Frequenz gemischt werden, wobei die Frequenz des zweiten und dritten Referenzsignals von der Frequenz des ersten Referenzsignals und der Frequenz des intensitätsmodulierten Signals verschieden ist. Auf diese Weise erhält man zwei Korrelationsfunktionen des Mischsignals, aus denen sich Amplitude und Phase des intensitätsmodulierten Signals berechnen lassen, wenn die Frequenzen und Phasen aller Signale bekannt sind.

Die erfindungsgemäße Vorrichtung ermöglicht es, mit nur einer einzigen Messung ("Single-Shot") Amplitude und Phase eines intensitätsmodulierten Signals zu erfassen. Auf diese Weise wird gegenüber dem Zeitmultiplex-Verfahren die Meßzeit um einen Faktor zwei reduziert und gegenüber dem Raummultiplex-Verfahren eine erhebliche Fläche auf dem Chip eingespart, so daß der Füllfaktor des Chips etwa verdoppelt ist.

Das Mischen des intensitätsmodulierten Signals im Gegentaktbetrieb, d.h. einmal mit dem ersten Referenzsignal und einmal mit einem dazu invertierten Signal gleicher Frequenz, ermöglicht eine vorteilhafte Differenzbildung zwischen den beiden erhaltenen Zwischensignalen zur Bildung des Mischsignals. Bei dieser Differenzbildung heben sich sämtliche Gleichanteile der Zwischensignale gegeneinander auf und das Mischsignal enthält ausschließlich die korrelierten Signalbestandteile. Auf diese Weise findet eine effektive Unterdrückung von nicht-korrelierten Hintergrundsignalen, z.B. aufgrund des Umgebungslichts statt. Weiterhin werden aber auch alle Asymmetrien des Mischers, welche sich beispielsweise aus der Prozessierung eins Bauelements ergeben können, ausgeglichen.

Das gleichzeitige Mischen des Mischsignals mit dem zweiten und dritten Referenzsignal ermöglicht eine im Gegensatz zum seriellen Zeitmultiplexverfahren parallele Erzeugung der Korrelationssignale und daher eine erhebliche Zeitersparnis bei der Messung. Der Zeitaufwand der Messung wird hierbei nochmals um etwa einen Faktor zwei verkürzt.

Ein geringer Zeitversatz, welcher insbesondere durch gleichartigen Schaltungsaufbau vermieden wird, ist dabei unbedeutend solange die sich ergebende relative Phasenverschiebung bekannt ist.

Erfindumpgemäß ist die Frequenz des zweiten Referenzsignals gleich der Differenzfrequenz zwischen der Frequenz des ersten Referenzsignals und der Frequenz des intensitätsmodulierten Signals. Die so erfolgende sogenannte Homodynmischung ermöglicht es, Meßsignalwerte zu erhalten, welche Werte zweier Autokorrelationsfunktionen des Mischsignals sind, so daß aus diesen die Amplitude und die Phase des intensitätsmodulierten Signals berechnet werden können.

Gemäß der Erfindung, wird ein Triggersignal durch Mischen des ersten Referenzsignals mit einem zu dem intensitätsmodulierten Signal proportionalen und phasenstarren Modulationssignal gebildet und das zweite Referenzsignal wird phasenstarr an das Triggersignal gekoppelt. Mit Hilfe dieser Kopplung läßt sich auf einfache Weise erreichen, daß die Phasen und Frequenzen aller Signale bekannt sind und nicht gegeneinander driften.

Weiterhin ist es zweckmäßig, wenn die Summe des ersten und des zweiten Zwischensignalwertes gebildet wird. Das Summensignal enthält ausschließlich die Gleichanteile, berücksichtigt also insbesondere nicht-korrelierte, bzw. nicht-intensitätsmodulierte Hintergrundsignale und ermöglicht die Angabe eines Maßes für die insgesamt auf den Mischer einfallende Intensität.

Sind die Phasen des zweiten und dritten Referenzsignals um 90° zueinander phasenverschoben, so erhält man als Meßsignalwerte Werte der zueinander senkrechten Quadraturkomponente der Korrelations- oder Autokorrelationsfunktionen.

Bezüglich der Vorrichtung sind daß Quellen für ein erstes, ein zweites und ein drittes Referenzsignal vorgesehen, wobei die Frequenz des ersten Referenzsignals von der Frequenz der Intensitätsmodulation verschieden ist, und mindestens ein Mischdetektorelement vorgesehen ist, wobei das Mischdetektorelement zum Mischen des intensitätsmodulierten Signals mit dem ersten Referenzsignal vorgesehen ist, und wobei die Vorrichtung zwei Einrichtungen zum Mischen des Ausgangssignals des Mischdetektorelements einerseits mit dem zweiten Referenzsignal und andererseits dem dritten Referenzsignal aufweist, wobei das zweite und das dritte Referenzsignal zueinander phasenverschoben sind.

Die erfindungsgemäße Ausgestaltung eines Mischdetektors ist vorteilhaft, da sie es ermöglicht, ohne Zeit- und Raummultiplex zwei Korrelationsfunktionen des von dem Mischdetektorelement ausgegebenen Signals zu erfassen und mit einer einzigen Messung gleichzeitig Amplitude und Phase des intensitätsmodulierten Signals zu bestimmen. Dafür werden an dem Mischdetektorelement weder mehr als zwei Ausleseelektroden benötigt, noch ist es notwendig, wie beim Zeitmultiplex zwischen den einzelnen Messungen der Korrelationsfunktionen die Phasen des ersten Referenzsignals zu verschieben.

Die parallele Auswertung der Korrelationsfunktionen ermöglicht eine um einen Faktor zwei schnellere Messung im Vergleich zu Zeitmultiplex-Vorrichtungen und eine Erhöhung des Füllfaktors des Detektorchips gegenüber Chips mit Raummultiplex-Detektoren ebenfalls um einen Faktor zwei.

Dabei ist es zweckmäßig, wenn die Vorrichtung zusätzlich eine Quelle für das intensitätsmodulierte Signal aufweist. Wird dieses Signal auf ein Objekt gerichtet, von diesem reflektiert und von dem Mischdetektorelement erfaßt, so kann aus der Phasenlage des erfaßten Signals auf den Abstand zwischen dem Objekt und dem Mischdetektorelement geschlossen werden.

Vorteilhaft ist es dabei, wenn die Quelle für das intensitätsmodulierte Signal eine Quelle für elektromagnetische Strahlung ist. Der bevorzugte Frequenzbereich der Strahlung liegt im sichtbaren oder nahinfraroten Bereich.

Auch wenn im folgenden primär auf eine Vorrichtung zur Erfassung von elektromagnetischer Strahlung abgestellt wird, so ist die beanspruchte Vorrichtung mit einem Mischdetektorelement für Ultraschallwellen ebenfalls zu verwenden.

Bevorzugt ist eine Ausführungsform der Erfindung, bei der das Mischdetektorelement ein Photomischdetektor, vorzugsweise ein PG-PMD-Element oder ein MSM-PMD-Element, ist. Dabei weist ein MSM-PMD-Element, so wie es in der vorliegenden Erfindung verwendet werden kann, zwei Ausleseelektroden mit einem dazwischenliegenden photoleitenden Halbleitermaterial auf. Die beiden Ausleseelektroden sind leitend mit dem photoleitenden Material verbunden. Die intensitätsmodulierte Strahlung fällt auf die photoleitende Schicht ein, während die Ausleseelektroden mit dem ersten elektrischen Referenzsignal moduliert sind. Die in der photoleitenden Schicht erzeugten Ladungsträger werden im elektrischen Feld der beiden Ausleseelektroden bewegt. Der erzeugte Strom bzw. die an den Ausleseelektroden erzeugten Spannungsschwankungen sind dann vom Produkt aus der Leitfähigkeit der photoleitenden Schicht und der angelegten Referenzspannung abhängig. Daher ist an den Ausleseelektroden ein Strom bzw. Spannungssignal abgreifbar, das von der Intensität der einfallenden elektromagnetischen Strahlung und der Phasendifferenz zwischen der Intensitätsmodulation und dem ersten Referenzsignal abhängig ist. Ein solcher Photomischdetektor kann jedoch auch eine komplexere Struktur aufweisen, so wie sie z.B. in der DE 198 21 974 A1 beschrieben ist. So können zusätzliche transparente Modulationsgates über der photoleitenden Schicht vorgesehen sein, an welche die Referenzspannung anlegbar ist, während die Ausleseelektroden lediglich zur Messung der Strom- bzw. Spannungsmodulation, d.h. dem gemischten Signal, verwendet werden. Solche PMD-Elemente mit zusätzlichen Modulationsgates werden als PG-PMD-Elemente bezeichnet. Auch können Anordnungen verwendet werden, bei denen zusätzliche Speichergates und Speicherstrukturen vorgesehen sind, so wie sie in der deutschen Patentanmeldung DE 10 2004 016 624 offenbart sind. Die Form der Elektroden hängt dabei von der konkreten Anwendung und vor allem von dem verwendeten photoleitenden Material, z.B. den Halbleitern Silicium oder Galliumarsenid, ab. Sie können punkt- oder streifenförmig (MSM) sein oder auch irgendeine andere geometrische Gestalt aufweisen. Grundsätzlich können alle aus dem Stand der Technik bekannten Mischdetektorelemente für die erfindungsgemäße Vorrichtung verwendet werden.

Weiterhin ist eine Einrichtung, vorzugsweise ein Differenzverstärker, zur Bildung des Differenzsignals zwischen den Ausgangssignale der beiden Ausleseelektroden vorgesehen. Dabei enthält das Differenzsignal der Ausgangssignale des Mischdetektorelements lediglich korrelierte Signalanteile.

Sind weiterhin Einrichtungen zum Bilden der Summe zwischen den Ausgangssignalen des Mischers vorgesehen, so hängt dieses Summensignal nur von den nicht-korrelierten Gleichanteilen des Mischsignals und daher von der Intensität der nicht-modulierten Umgebungssignale ab. Das so gewonnene Summensignal kann nachfolgend in Einrichtungen zur Signalverarbeitung, beispielsweise einem Integrator, ausgewertet werden.

In einer besonders bevorzugten Ausführungsform der Erfindung sind das zweite und das dritte Referenzsignal um 90° zueinander phasenverschobenen. Auf diese Weise erhält man in den Ausgängen der Mischer die gerade und ungerade Korrelationsfunktionen aus denen mit besonders großer Genauigkeit die Phase und die Amplitude des intensitätsmodulierten Signals bestimmbar sind.

Dabei ist es zweckmäßig, wenn die Frequenz des zweiten und dritten Referenzsignals gleich der Differenzfrequenz zwischen der Frequenz der Intensitätsmodulation des intensitätsmodulierten Signals und dem ersten Referenzsignal ist, wobei das zweite und dritte Referenzsignal phasenstarr an diese Differenzfrequenz gekoppelt sind. Auf diese Weise erhält man im Ausgang der beiden Mischer zwei Autokorrelationssignale. Aus ihnen läßt sich die Phase des intensitätsmodulierten Signals berechnen.

Besonders bevorzugt ist eine Ausführungsform der Erfindung, bei der das Differenzsignal zwischen den beiden Ausgangssignalen des Mischdetektorelements mit Hilfe eines sogenannten IQ-Mischers verarbeitet werden. Solche IQ-Mischer sind als digitale oder analoge Bauelemente kommerziell erhältlich. Dabei steht die Abkürzung IQ für "In-phase-Quadrature", was andeutet, daß das Eingangssignal in dem Mischer mit einem zweiten Referenzsignal gemischt wird, das relativ zu einem anderen dritten Referenzsignal um 90° phasenverschoben ist. Zur Erhöhung der Meßgenauigkeit der Phase können die Mischer 12 und 13 wie das in der Vorrichtung vorhandene Misch-Detektorelement als Gegentaktmischer ausgeführt sein.

In einer alternativen Ausführungsform der Erfindung sind anstelle eines IQ-Mischers oder zweier diskreter Mischerelemente zwei getrennte Differenzverstärker vorgesehen sein, welche parallel zueinander die Differenz zwischen den beiden Ausgangssignalen des Mischdetektorelements bilden. Werden diese Differenzverstärker an ihrem Versorgungs- bzw. Leistungsanschluß mit einem modulierten Signal beschaltet, so wird dieses Signal unmittelbar mit dem Differenzsignal zwischen den Ausgangssignalen des Mischdetektorelements gemischt. Legt man nun wie zuvor an die Differenzverstärker zwei zueinander phasenverschobene zweite und dritte Referenzsignale an, so erhält man im Ausgang der Differenzverstärker wieder die den Korrelationsfunktionen entsprechenden Signale. Besonders bevorzugt ist dabei eine Ausführungsform der Erfindung, bei der in Signalrichtung hinter dem mindestens einen Differenzverstärker oder auch hinter den beiden Einrichtungen zum Mischen ein Analog-Digital-Wandler vorgesehen ist, so daß die weitere Signalverarbeitung digital erfolgen kann.

Dabei ist es zweckmäßig, wenn die Integrationszeit des Sample-Hold-Glieds vor dem Analog-Digital-Wandler gleich einem ganzzahligen Vielfachen des Kehrwerts der Frequenz des zweiten Referenzsignals ist.

In einer besonders bevorzugten Ausführungsform der Erfindung ist mindestens ein Teil der Elemente der Vorrichtung auf einem Chip integriert. Dabei ist es insbesondere zweckmäßig, wenn das Mischdetektorelement, der Differenz- und Summenverstärker sowie ein Analog-Digital-Wandler hinter dem Differenzverstärker auf dem Chip integriert sind. Auf diese Weise läßt sich ein digitales Signal zur weiteren Verarbeitung, insbesondere zur Mischung mit dem zweiten und dritten Referenzsignal vom Chip wegführen. Darüber hinaus können mehrere Mischdetektorelemente mit ihren nachgeschalteten Bauelementen auf einem Chip zu einem Detektorarray integriert sein. Dabei bildet jedes Mischdetektorelement einen Bildpunkt eines Bilderfassungschips zur Erfassung eines dreidimensionalen Bildes. Dabei ist es zweckmäßig, wenn der Chip in CMOS-Technologie ausgeführt ist.

In einer alternativen Ausführungsform der Erfindung ist es zweckmäßig, wenn jeweils ein oder mehrere Mischdetektorelemente mit jeweils zwei nachgeschalteten Differenzverstärkern auf dem Chip integriert sind, so daß bereits die Quadratursignale in analoger oder auch digitaler Form von dem Bilderfassungschip weggeführt werden können.

In einer besonders bevorzugten Ausführungsform der Erfindung sind die Ausleseelektroden des Mischdetektorelements mit Einrichtungen zum Ableiten von unerwünschten, insbesondere durch Fremdlicht erzeugten Ladungsträgern aus dem Misch-Detektorelement verbunden. So läßt sich das im wesentlichen durch nicht moduliertes Fremdlicht erzeugte Gleichtaktsignal erheblich, d.h. insbesondere bis in den linearen Ausstreuerbereich unterdrücken, während das Gegentakt-Nutzsignal kaum beeinträchtig wird. Diese Einrichtungen zum Ableiten sind periodisch betreibbar.

Auf diese Weise wird die in dem Mischdetektorelement erfolgende Integration des Signals in regelmäßigen Abständen unterbrochen. Die angesammelten Ladungsträger fließen dann ab, so daß der Integrationsprozeß erneut beginnen kann. Auf diese Weise wird ein Überlaufen der Mischdetektorelemente verhindert.

Um die Störungen durch das Zurücksetzen des Mischdetektorelements auf die restliche Vorrichtung so gering wie möglich zu halten, ist es zweckmäßig, die beiden Ausleseelektroden bzw. die intergierenden Elemente des Mischdetektors gleichzeitig nach Intervallen zurückzusetzen, welche einem ganzzahligen Vielfachen der Periodenlänge des Ausgangssignals des Mischdetektors entsprechen. Weiterhin ist es vorteilhaft, wenn das Zurücksetzen in einem Nulldurchgang der Schwingung des Mischsignals erfolgt.

Um darüber hinaus die Störeinflüsse auf den restliche Schaltung durch das Zurücksetzen zu minimieren ist es vorteilhaft, wenn die Ausleseelektroden mit Einrichtungen zum Abkoppeln des Mischdetektorelements vom Rest der Schaltung verschaltet sind. Diese Einrichtungen zum Abkoppeln sind im wesentlichen synchron zu den Einrichtungen zum Zurücksetzen betreibbar und koppeln den Mischdetektor immer dann vom restlichen Schaltkreis ab, wenn der Mischdetektor zurückgesetzt wird. Dabei sind die Einrichtungen zum Abkoppeln in Signalrichtung hinter den Einrichtungen zum Ableiten angeordnet. Besonders zweckmäßig ist es dabei, wenn das Wiederankoppeln des Mischdetektorelements, d.h. der Beginn der beiden folgenden Integrationszeiten, immer unmittelbar nach dem Zurücksetzen und noch während des Nulldurchgangs des Mischsignals erfolgt. Die Integrationszeiten des Mischerelementes sollten dabei vorzugsweise ein ganzzahliges Vielfaches des Kehrwerts der Frequenz des Mischsignals betragen und zusätzlich eine Haltezeit vor dem nächsten Rücksetzen aufweisen.

Die Einrichtungen zum Ableiten der Ladungsträger und zum Abkoppeln des Mischdetektorelements können einfache Schalter oder in einer bevorzugten Ausführungsform Metall-Oxid-Halbleiter-Feldeffekttransistoren (MOS-FETs) sein.

Weitere Vorteile, Merkmale und Anwendungsmöglichkeiten der vorliegenden Erfindung werden anhand der folgenden Beschreibung einer bevorzugten Ausführungsform und der dazugehörigen Figuren deutlich.

Figur 1     zeigt schematisch eine erste Ausführungsform der erfindungsgemäßen Vorrichtung.
Figur 2     zeigt schematisch eine alternative Ausführungsform der erfindungsgemäßen Vorrichtung.
Figur 3     zeigt schematisch eine dritte Ausführungsform der erfindungsgemäßen Vorrichtung.

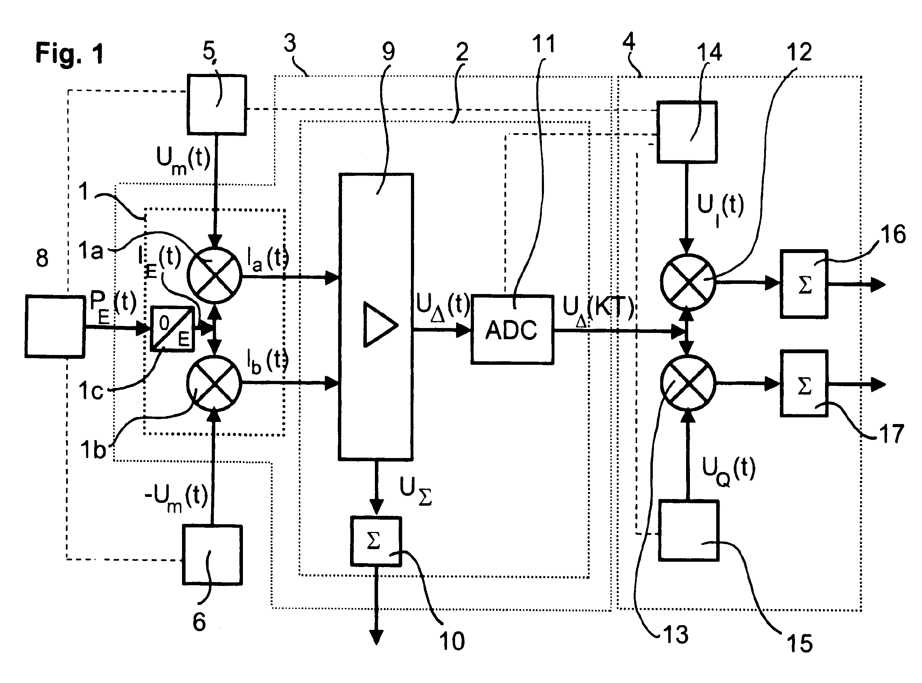

In Figur 1 ist eine schematische Ansicht einer bevorzugten Ausführungsform der vorliegenden Erfindung dargestellt. Anhand der Figur wird nachfolgend sowohl eine bevorzugte Ausführungsform der erfindungsgemäßen Vorrichtung als auch die Funktionsweise des Verfahrens beschrieben.

Die Vorrichtung weist das Photomischerelement 1, welches als PMD-Element ausgestaltet ist, und die Ausleseschaltung 2 auf. Das PMD-Mischerelement 1, die Ausleseschaltung 2 einschließlich eines Analog-Digital-Wandlers 11 sind dabei auf einem einzigen Chip 3 integriert. Außerhalb des Chip 3 ist eine digitale IQ-Mischerschaltung 4 angeordnet.

Dabei könnte alternativ die IQ-Mischerschaltung 4 auch in Form einer Analogschaltung ausgestaltet und ebenfalls auf dem Chip 3 zusammen mit den anderen Baugruppen 1, 2 integriert sein.

Das dargestellte MSM-PMD-Mischerelement 1 besteht aus zwei leitend mit einer dazwischenliegenden photoleitenden Halbleiterschicht verbundenen Ausleseelektroden. Das PMD-Mischerelement 1 ist für den Gegentaktbetrieb verschaltet. Zum besseren Verständnis des Detektionsverfahrens ist das PMD-Mischerelement 1 als Ersatzschaltbild mit zwei getrennten Mischern 1a, 1b und einem Detektor 1c für die einfallende elektromagnetische Strahlung dargestellt. In dem Detektor 1c wird die einfallende elektromagnetische Strahlung $P_E(t)$ in ein Stromsignal $I_E(t) = S \, P_E(t)$ umgesetzt, wobei S die Sensitivität des Mischdetektorelements ist.

Das Ersatzschaltbild macht besonders deutlich, daß an den beiden Ausleseelektroden des PMD-Mischerelements zwei zueinander invertierte Referenzsignale anliegen und für korrelierte Signale ebenfalls zueinander invertierte Mischsignale an den beiden Ausleseelektroden des PMD-Mischerelements 1 abgreifbar sind. Tatsächlich sind jedoch die mit 1a und 1b bezeichneten Mischer identisch und in einem einzigen PMD-Mischerelement realisiert.

Nicht-korrelierte Signale $P_E(t)$ und $\pm \, U_m(t)$ ergeben in der Summe bzw. in der Integration über eine Mindestzeit der längsten relevanten Signalperiode von $P_E(t)$ oder $\Delta U_m(t) = 2 \, U_m(t)$ oder einem ganzzahligen Vielfachen derselben immer gleiche Mittelwerte für $I_a(t)$ und $I_b(t)$.

Korrelierte Signale $P_E(t)$ und $\pm \, U_m(t)$ ergeben in der Summe bzw. in der Integration über eine Mindestzeit der längsten relevanten Signalperiode oder einem ganzzahligen Vielfachen derselben immer Gegentaktwerte für $I_a(t)$ und $I_b(t)$.

Eine der Ausleseelektroden des PMD-Mischerelements 1 ist mit einer ersten Referenzspannung $U_m(t)$ beaufschlagt. Demgegenüber liegt an der zweiten Ausleseelektrode des PMD-Mischerelements 1 ein dazu invertiertes Referenzsignal $-U_m(t)$ an. Die Frequenzen bzw. Kreisfrequenzen $\omega_2$ der beiden Referenzsignale $U_m(t)$ und $-U_m(t)$ sind dabei identisch. Dabei können die Referenzsignale beliebige periodische oder quasi-periodische Signale sein, wobei im folgenden der Einfachheit halber davon ausgegangen wird, daß beide Referenzsignale Kosinussignale der Form $U_m(t) = \cos \omega_2 \cdot t$ sind.

Auf die photoleitende Halbleiterschicht des PMD-Photomischers 1 fällt ein intensitätsmoduliertes optisches Strahlungssignal $P_E(t)$ der Form $A \cdot \sin(\omega_1 t - \Phi)$ ein. Dabei bezeichnet A die Amplitude des optischen Strahlungssignals, $\omega_1$ dessen Frequenz und $\Phi$ die Phasenlage des Signals. Im Photomischdetektor wird das elektromagnetische Eingangssignal $P_E(t)$ in ein Stromsignal $I_E(t)$ umgesetzt.

Die Modulationsfrequenz der Intensitätsmodulation der einfallenden elektromagnetischen Strahlung beträgt in der dargestellten Ausführungsform 20 MHz.

Die Frequenz der Referenzsignale Um und -Um sind dazu um 50 kHz verschoben, betragen also 20,05 MHz.

Das elektromagnetische Eingangssignal $P_E(t)$ bzw. dessen Stromsignal $I_E(t)$ wird in dem PMD-Mischerelement 1 mit dem Referenzsignal $U_m(t)$ im Gegentaktbetrieb gemischt. Auf diese Weise erhält man auf den Ausleseelektroden des PMD-Mischerelements 1 zwei zueinander invertierte Signale $I_a(t)$ und $I_b(t)$, wobei $I_a(t) \sim A \sin(\Delta\omega t - \Phi)$ und $I_b(t) \sim A \, -\sin(\Delta\omega t - \Phi)$. Dabei ist $\Delta\omega$ die Differenz zwischen den Kreisfrequenzen $\omega_1$ und $\omega_2$ des optischen Strahlungssignals $P_E(t)$ bzw. des elektrischen Referenzsignals $U_m(t)$.

Die Ausgangssignale $I_a(t)$, $I_b(t)$ des PMD-Mischerelements 1 werden mit Hilfe der Ausleseschaltung 2 ausgelesen. Dabei besteht die Ausleseschaltung 2 im wesentlichen aus einem Differenz- und Summenverstärker 9, einem Integrator 10 und einem Analog-Digital-Wandler 11. Mit Hilfe des Differenz- und Summenverstärkers 9 wird sowohl die Differenz $I_a(t) - I_b(t)$ zwischen den Ausgangssignalen des PMD-Mischers 1 als auch die Summe $I_a(t) + I_b(t)$ gebildet. Das Summensignal $U_\Sigma$ ist abhängig von den nicht-korrelierten Signalanteilen der auf das PMD-Element einfallenden elektromagnetischen Strahlung, so daß das in dem nachfolgenden Integrator 10 aufintegrierte Summensignal ein Maß für die Intensität der nicht-modulierten Strahlung ist, welche auf den Detektor trifft.

Das Ausgangssignal $U_\Delta(t)$ des Differenzverstärkers ist ein Spannungssignal, welches abhängig ist von dem Term $A \sin(\Delta\omega t - \phi)$. Es enthält sowohl die Information über die Amplitude A des modulierten Strahlungssignals als auch über dessen Phasenlage $\Phi$.

In der dargestellten Ausführungsform der Erfindung wird das Differenzsignal $U_\Delta(t)$ mit Hilfe eines Analog-Digital-Wandlers 11, welcher sich ebenfalls auf dem Chip 3 befindet, in ein Digitalsignal $U_\Delta(KT)$ gewandelt. Das digitalisierte Ausgangssignal $U_\Delta(KT)$ wird vom Chip weg in eine digitale IQ-Mischerschaltung 4 geführt. In alternativen Ausführungsformen kann jedoch der Analog-Digital-Wandler 11 entfallen, so daß die IQ-Mischerschaltung 4 ebenfalls analog ausgeführt sein kann.

Das digitalisierte Differenzsignal $U_\Delta$ wird nun parallel auf zwei diskrete Mischer gegeben. Dort werden sie jeweils mit einem zweiten bzw. dritten Referenzsignal $U_I(t)$ bzw. $U_Q(t)$ gemischt. Die von den Quellen 14 und 15 erzeugten

**6**

zweiten und dritten Referenzsignale $U_I(t)$, $U_Q(t)$ weisen die gleiche Kreisfrequenz $\Delta\omega$ auf wie das Mischsignal zwischen dem intensitätsmodulierten Strahlungssignal $P_E(t)$ und dem ersten Referenzsignal $U_m(t)$.

Die Referenzsignale $U_i(t)$ und $U_Q(t)$ sind außerdem phasenstarr an das Mischsignal $U_\Delta(t)$ gekoppelt, was durch die gestrichelte Verbindung zwischen den Quellen 14 und 15 bzw. 5, 6, 8 angedeutet ist. Um diese Kopplung zu erreichen, wird das erste Referenzsignal zusätzlich mit dem den Modulator der Quelle 8 treibenden Signal gemischt. Das so erzeugte Triggersignal hat ebenfalls die Kreisfrequenz $\Delta\omega$ und weist eine feste Phasenbeziehung zum Mischsignal $U_\Delta(t)$ auf. Die Quellen 14, 15 für das zweite und dritte Referenzsignal sind nun phasenstarr an das Triggersignal gekoppelt, wodurch gleichzeitig die Kopplung an $U_\Delta(t)$ gegeben ist.

Das zweite Referenzsignal $U_I(t)$ wird auch als In-Phase-Signal bezeichnet, wobei seine absolute Phasenlage in Bezug auf das Differenzsignal $U_\Delta(KT)$ willkürlich gewählt sein kann. Das dritte Referenzsignal $U_Q(t)$ wird als Quadratursignal bezeichnet und ist gegenüber dem zweiten Referenzsignal $U_I(t)$ um 90° phasenverschoben. Daher können die zweiten und dritten Referenzsignale $U_I(t)$, $U_Q(t)$ auch als Sinus- und Kosinussignale beschrieben werden. Die Ausgangssignale der beiden Mischerelemente 12, 13 sind, da es sich um eine Homodynmischung handelt, abhängig vom Sinus bzw. Kosinus der Phasenlage $\phi$ des optischen Strahlungssignals $P_E(t)$. Die Ausgangssignale der Mischer 12, 13 entsprechen daher den geraden (Kosinus) und ungeraden (Sinus) Autokorrelationsfunktionen. Aus diesen beiden Funktionen läßt sich die Phasenlage $\phi$ des optischen Strahlungssignals $P_E(t)$ als $\arctan\dfrac{\sin-\Phi}{\cos-\Phi}$ berechnen. Die Summationsglieder 16, 17 ermöglichen es, die Ausgangs-signale der Mischerelemente 12, 13 aufzusummieren, wobei die Summation jeweils über ein Zeitintervall erfolgen muß, welches dem Kehrwert $T_\Delta = \dfrac{1}{\Delta f}$ der Taktfrequenz des Sample-Hold-Glieds des Analog-Digital-Wandlers 11 entspricht.

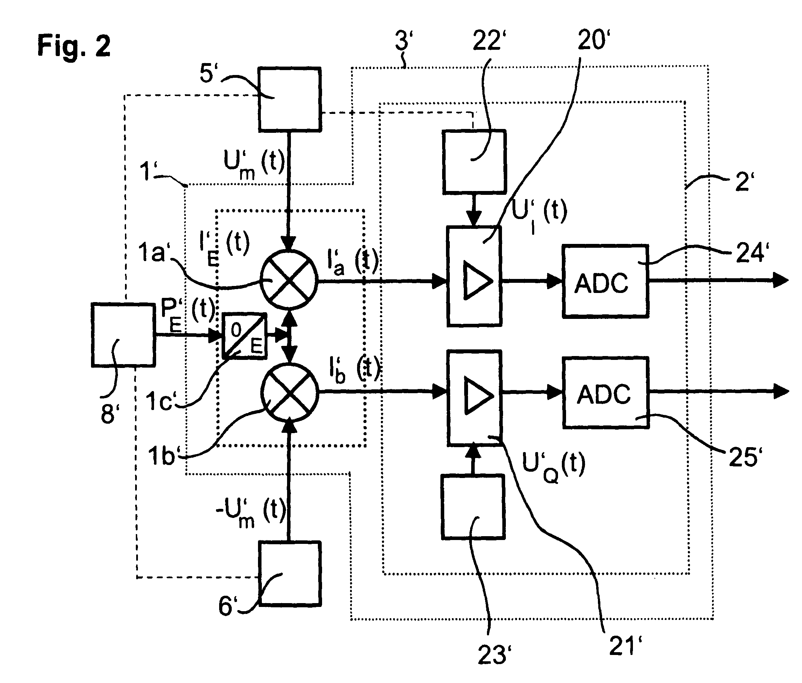

In Figur 2 ist schematisch eine weitere Ausführungsform der vorliegenden Erfindung dargestellt. Dabei sind das MSM-PMD-Mischerelement 1' sowie die Quelle 8' der modulierten elektromagnetischen Strahlung $P_E(t)$ als auch die Quellen 5' und 6' für das Referenzsignal $U_m(t)$, $-U_m(t)$ identisch mit denen aus Figur 2. Die beiden Ausleseelektroden des PMD-Elements 1' sind jedoch jeweils mit zwei parallelgeschalteten Differenzverstärkern 20', 21' in der Ausleseschaltung 2' verbunden. Darüber hinaus sind die beiden Ausleseelektroden des PMD-Elements 1' mit einem Summenverstärker zur Bildung der Summe der beiden Signale auf den Ausleseelektroden verbunden. Dieser Summenverstärker ist jedoch zur Vereinfachung nicht dargestellt.

In den Differenzverstärkern 20' und 21' wird die Differenz zwischen den beiden Signalen $I_a(t)$ und $I_b(t)$ der Ausleseelektroden des PMD-Elements 1' gebildet. Die Leistungsanschlüsse sind mit einem zweiten bzw. dritten Referenzsignal $U_I(t)$ bzw. $U_Q(t)$ beaufschlagt. Diese Signale werden von Quellen 22' bzw. 23' erzeugt, wobei diese identisch mit den Quellen 14, 15 der in Figur 1 dargestellten Ausführungsform sind. Die Frequenzen der Referenzsignale $U_i(t)$ und $U_Q(t)$ sind gleich der Differenzfrequenz zwischen der Frequenz der Intensitätsmodulation der auf das PMD-Element einfallenden elektromagnetischen Strahlung $P'_E(t)$ und der Frequenz des ersten Referenzsignals $U'_m(t)$. Darüber hinaus sind die Quellen 22', 23' auf das Signal dieser Frequenz phasengelockt.

Aufgrund der nicht-linearen Eigenschaften der Differenzverstärker 20', 21' wird in den Differenzverstärkern nicht nur das Differenzsignal $U'_\Delta$ gebildet, sondern das Differenzsignal wird gleichzeitig mit den Referenzfrequenzen $U_I(t)$ bzw. $U_Q(t)$ gemischt. Daher erhält man in den Ausgängen der Differenzverstärker 20', 21' unmittelbar die Quadraturkomponenten des Signals bzw. die ungeraden und geraden Autokorrelationsfunktionen. Die Signale hinter den beiden Differenzverstärkern 20', 21' entsprechen den Signalen hinter den Mischern 12, 13 der in Figur 1 dargestellten Ausführungsform. Da die Quadratursignale in Figur 2 in analoger Form vorliegen, sind hinter den Differenzverstärkern 20', 21' je ein Analog-Digital-Wandler 24' bzw. 25' angeordnet, so daß die Quadratursignale zur weiteren Verarbeitung in digitaler Form von dem Chip 3' weggeführt werden können.

Die in den Figuren 1 und 2 dargestellten PMD-Elemente 1, 1' und Ausleseschaltungen 2, 2' stellen Ausschnitte aus einem zweidimensionalen Array zur Bilderfassung dar. Dabei ist jedem PMD-Element 1, 1' eine Ausleseschaltung 2, 2' und je zwei weitere Mischer zugeordnet. Die innerhalb der gestrichelten Umrandung 3' liegenden Elemente sind dabei jeweils auf dem Bilderfassungschip integriert, so daß dieser Digitalsignale zur weiteren Signal- und Bildverarbeitung abgibt.

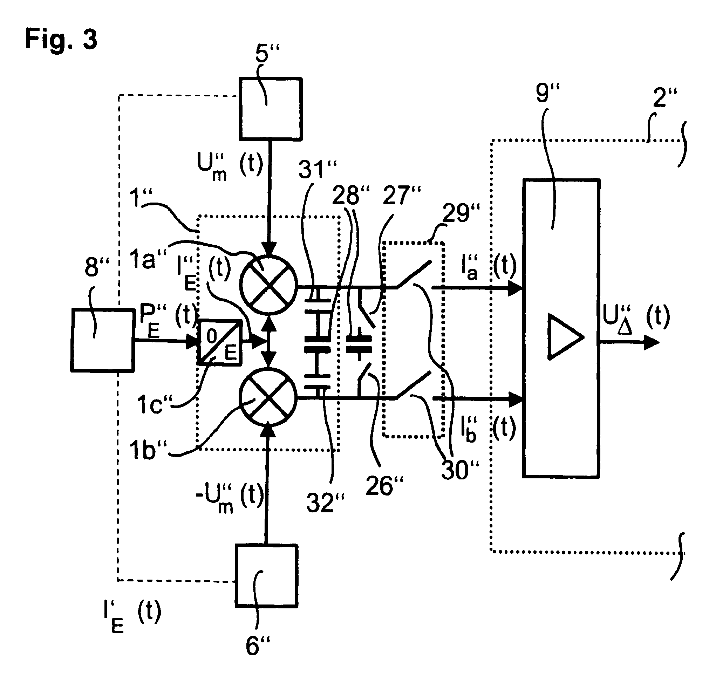

In Figur 3 ist eine alternative Ausführungsform der Erfindung dargestellt, wobei der besseren Übersicht halber nur das PMD-Mischerelement 1", die Quellen 5", 6" und 8" für das intensitätsmodulierte Strahlungssignal $P''_E(t)$ und das erste Referenzsignal $U''_m(t)$, sowie der Differenzverstärker 9" dargestellt sind. Soweit ist die dargestellte Vorrichtung im Aufbau identisch mit der in Figur 1 gezeigten Ausführungsform. Das PMD-Mischerelement ist ein PG-PMD-Element, weist also gegenüber dem MSM-PMD-Elementen aus den Figuren 1 und 2 zwei zusätzliche Modulationsgates auf, welche anstelle der Ausleseelektroden mit dem ersten Referenzsignal im Gegentaktbetrieb beschaltet sind. Das PG-PMD-Element zeigt zusätzliche Streukapazitäten 31" bzw. 32", welche eine Integration der generierten Mischsignale bewirken.

Die abgebildete Vorrichtung weist daher gegenüber den in den Figur 1 und 2 dargestellten Ausführungsformen zusätzliche Einrichtungen zum Ableiten der auf dem PMD-Mischerelement akkumulierten Ladungen sowie zum Abkoppeln des PMD-Mischerelements 1" vom restlichen Schaltungsaufbau, insbesondere vom Differenzverstärker 9" auf.

Die Elemente zum Ableiten der auf dem PMD-Element 1" angesammelten Ladungsträger bestehen aus zwei Schaltern 26", 27", welche im geschlossenen Zustand einen direkten Abfluß der Ladungsträger aus dem PMD-Mischerelement über die Ausleseelektroden des Elements auf Masse 28" ermöglichen. Dabei sind die schematisch als Schalter dargestellten Elemente 26", 27" als MOSFET-Transistoren realisiert. Die Schalter werden gleichzeitig periodisch angesteuert, so daß nach einem vorgegebenen Integrationsintervall das PMD-Element 1" zurückgesetzt wird und alle Ladungsträgeransammlungen abfließen können. Dies ist vorteilhaft, da auf diese Weise ein Überlaufen des Elements 1" verhindert wird. Dabei beträgt das Integrationsintervall zwischen zwei Zurücksetzvorgängen genau einem ganzzahligen Vielfachen der Modulationsfrequenz der Signale $I_a(t)$ bzw. $I_b(t)$

Um Störeinflüsse dieses periodischen Zurücksetzens des PMD-Elements 1" auf die nachgeschaltete Ausleseschaltung 9" und damit auf das Mischsignal $U''_\Delta(t)$ zu verhindern, ist zusätzlich eine Einrichtung 29" zum Abkoppeln des PMD-Elements 1" von der Ausleseschaltung 2" vorgesehen. So besteht die Einrichtung 29" zum Abkoppeln des PMD-Elements 1" aus zwei weiteren MOSFETs, welche schematisch als Schalter 30" dargestellt sind. Jeweils kurz vor dem Zurücksetzen des PMD-Elements 1" durch Schließen der Schaltelemente 26", 27" wird das PMD-Element 1" mit Hilfe der Schalter 30" von der nachfolgenden Ausleseschaltung 2" abgekoppelt, so daß das Zurücksetzen keine Störung der nachfolgenden Schaltung 2" hervorruft. In der dargestellten Ausführungsform ist die Periodizität, mit der das PMD-Element 1" von der nachfolgenden Ausleseschaltung 3" abgekoppelt wird, gleich einem ganzzahligen Vielfachen der Periodizität der Mischsignale $I''_a(t)$, $I''_b(t)$. Um die Störeinflüsse weiter zu minimieren, wird das PMD-Element 1" genau beim Nulldurchgang der Mischsignale $I''_a(t)$, $I''_b(t)$ wieder an die Ausleseschaltung angekoppelt.

Für Zwecke der ursprünglichen Offenbarung wird darauf hingewiesen, daß sämtliche Merkmale, wie sie sich aus der vorliegenden Beschreibung, den Zeichnungen und den Ansprüchen für einen Fachmann erschließen, auch wenn sie konkret nur im Zusammenhang mit bestimmten weiteren Merkmalen beschrieben wurden, sowohl einzeln als auch in beliebigen Zusammenstellungen mit anderen der hier offenbarten Merkmale oder Merkmalsgruppen kombinierbar sind, soweit dies nicht ausdrücklich ausgeschlossen wurde oder technische Gegebenheiten derartige Kombinationen unmöglich oder sinnlos machen. Auf die umfassende, explizite Darstellung sämtlicher denkbarer Merkmalskombinationen wird hier nur der Kürze und der Lesbarkeit der Beschreibung wegen verzichtet.

## BEZUGSZEICHENLISTE

| | |
|---|---|
| 1, 1', 1" | Photomischerelement |
| 1c, 1c', 1c" | Komponenten des Photomischerelements 1, 1', 1" im Ersatzschaltbild |
| 1a, 1a', 1a" | Komponenten des Photomischerelements 1, 1', 1" im Ersatzschaltbild |
| 1b,1b'1b" | Komponenten des Photomischerelements 1, 1', 1" im Ersatzschaltbild |
| 2, 2', 2" | Ausleseschaltung |
| 3, 3' | Chip |
| 4 | digitales IQ-Mischerelement |
| 5, 6; 5', 6', 5", 6" | Referenzsignalquellen |
| 8, 8', 8" | Quelle der modulierten elektrischen Strahlung |
| 9, 9" | Differenz- und Summenverstärker |
| 10 | Integrator |
| 11 | Analog-Digital-Wandler |
| 12, 13 | Mischerelemente |
| 14, 15 | Quellen |
| 16, 17 | Summationsglieder |
| 20', 21' | parallelgeschaltete Differenzverstärker |
| 22', 23' | Quellen |
| 24', 25' | Analog-Digital-Wandler |
| 26", 27" | Schalter |
| 28" | Masse |
| 29" | Einrichtung zum Abkoppeln des PMD-Elements von der Ausleseschaltung |
| 30" | Schalter |
| 31", 32" | Streukapazitäten |

**EP 1 635 452 B1**

**Patentansprüche**

1. Vorrichtung zum Erfassen der Phasenlage der Intensitätsmodulation eines intensitätsmodulierten Signals mit einem Mischdetektorelement mit zwei Ausleseelektroden, wobei das Mischdetektorelement zum Mischen des intensitätsmodulierten Signals mit einem ersten Referenzsignal vorgesehen ist, einer Quelle für das intensitätsmodulierte Signal, wobei die Quelle einen Modulator zum Modulieren der Intensität des Signals mit einer Frequenz zwischen 500 kHz und 500 MHz aufweist, und Quellen für ein erstes, ein zweites und ein drittes Referenzsignal, wobei die Quelle für das erste Referenzsignal so eingerichtet ist, dass die Frequenz des ersten Referenzsignals von der Frequenz der Intensitätsmodulation verschieden ist, wobei die Quelle für das zweite Referenzsignal und die Quelle für das dritte Referenzsignal so eingerichtet sind, dass die Frequenz des zweiten Referenzsignals gleich der Frequenz des dritten Referenzsignals ist und dass die Frequenz des zweiten und dritten Referenzsignals von der Frequenz des ersten Referenzsignals verschieden ist und dass das zweite und das dritte Referenzsignal zueinander phasenverschoben sind, mit einer Einrichtung zur Bildung des Differenzsignals zwischen den Ausgangssignalen der beiden Ausleseelektroden, mit einer Einrichtung zum Mischen, die so eingerichtet ist, dass sie das Ausgangssignal der Einrichtung zur Bildung des Differenzsignals zwischen den Ausgangssignalen der beiden Ausleseelektroden mit dem zweiten Referenzsignal mischt, mit einer Einrichtung zum Mischen, die so eingerichtet ist, dass sie das Ausgangssignal der Einrichtung zur Bildung des Differenzsignals zwischen den Ausgangssignalen der beiden Ausleseelektroden mit dem dritten Referenzsignal mischt, mit einer Einrichtung zum Mischen des ersten Referenzsignals mit dem den Modulator treibenden Signal, so dass ein Triggersignal erzeugt wird, das die Differenzfrequenz zwischen der Frequenz der Intensitätsmodulation des intensitätsmodulierten Signals und der Frequenz des ersten Referenzsignals aufweist, und mit einer Einrichtung zum phasenstarren Koppeln des zweiten und dritten Referenzsignals an das Triggersignal, wobei in Signalrichtung hinter den Einrichtungen zum Mischen eine Auswerteeinheit zum Bestimmen der Phasenlage des intensitätsmodulierten Signals vorgesehen ist.

2. Vorrichtung nach Anspruch 1, **dadurch gekennzeichnet, daß** die Einrichtungen zur Differenzbildung in Signalrichtung vor den Einrichtungen zum Mischen angeordnet sind.

3. Vorrichtung nach einem der Ansprüche 1 oder 2, **dadurch gekennzeichnet, daß** die Phasen des zweiten und dritten Referenzsignals um 90° zueinander phasenverschoben sind

4. Vorrichtung nach einem der Ansprüche 1 bis 3, **dadurch gekennzeichnet, daß** sie eine Einrichtung, vorzugsweise einen Summenverstärker, zum Bilden des Summensignals zwischen den Ausgangssignalen der beiden Ausleseelektroden aufweist.

5. Vorrichtung nach einem der Ansprüche 1 bis 4, **dadurch gekennzeichnet, daß** das Mischdetektorelement ein Photomisch-Detektor, vorzugsweise ein PG-PMD-Element oder ein MSM-PMD-Element, ist.

6. Vorrichtung nach einem der Ansprüche 1 bis 5, **dadurch gekennzeichnet, daß** sie eine Quelle für ein zum ersten Referenzsignal invertiertes Referenzsignal aufweist und das Mischdetektorelement zum Mischen des intensitätsmodulierten Signals mit dem ersten Referenzsignal und auch dem dazu invertierten Signal vorgesehen ist.

7. Vorrichtung nach Anspruch 1, **dadurch gekennzeichnet, daß** die Quelle für das intensitätsmodulierte Signal eine Quelle für elektromagnetische Strahlung, vorzugsweise für Strahlung im sichtbaren Spektralbereich und besonders bevorzugt im infraroten Spektralbereich, ist.

8. Vorrichtung nach einem der Ansprüche 1 bis 7, **dadurch gekennzeichnet, daß** die Differenzfrequenz zwischen der Frequenz der Intensitätsmodulation des intensitätsmodulierten Signals und der Frequenz des ersten Referenzsignals zwischen 1 kHz und 100 kHz, vorzugsweise zwischen 30 kHz und 70 kHz und besonders bevorzugt 50 kHz beträgt.

9. Vorrichtung nach einem der Ansprüche 1 bis 8, **dadurch gekennzeichnet, daß** die Einrichtungen zum Mischen in digitaler Schaltungstechnik ausgeführt sind.

10. Vorrichtung nach einem der Ansprüche 1 bis 9, bis **dadurch gekennzeichnet, daß** die Einrichtungen zum Mischen in einem IQ-Mischerelement integriert sind.

11. Vorrichtung nach einem der Ansprüche 1 bis 10, **dadurch gekennzeichnet, daß** die Einrichtungen zum Mischen mindestens zwei Differenzverstärker sind, wobei der Versorgungsanschluß eines ersten Differenzverstärkers mit der zweiten Referenzfrequenz moduliert ist und der Versorgungsanschluß eines zweiten Differenzverstärkers mit der dritten Referenzfrequenz moduliert ist.

12. Vorrichtung nach Anspruch 11, **dadurch gekennzeichnet, daß** in Signalrichtung hinter dem Differenzverstärker ein Analog-Digitalwandler vorgesehen ist.

13. Vorrichtung nach einem der Ansprüche 1 bis 12, **dadurch gekennzeichnet, daß** mindestens ein Teil der Elemente der Vorrichtung auf einem Chip integriert ist.

14. Vorrichtung nach einem der Ansprüche 1 bis 13, **dadurch gekennzeichnet, daß** die Ausleselektroden des Mischdetektorelements mit Einrichtungen zum Ableiten von Ladungsträgem aus dem Mischdetektorelement verbunden sind.

15. Vorrichtung nach einem der Ansprüche 1 bis 14, **dadurch gekennzeichnet, daß** Einrichtungen zum Abkoppeln des Mischdetektorelements von der restlichen Vorrichtung vorgesehen sind.

16. Vorrichtung nach Anspruch 14 oder 15, **dadurch gekennzeichnet, daß** die Einrichtungen zum Ableiten und/oder Abkoppeln Transistoren, vorzugsweise MOS-FETs sind.

17. 3D-Kamera mit einer Abbildungsoptik und einem Array von Vorrichtungen nach einem der Ansprüchen 1-16.

## Claims

1. Device for detecting the phase position of the intensity modulation of an intensity-modulated signal
with a mixer detector element with two read-out electrodes,
wherein the mixer detector element is provided with a first reference signal for mixing the intensity-modulated signal,
a source for the intensity-modulated signal,
wherein the source has a modulator for modulating the intensity of the signal with a frequency of between 500 kHz and 500 MHz, and
sources for a first, a second and a third reference signal,
wherein the source for the first reference signal is set up such that the frequency of the first reference signal is different from the frequency of the intensity modulation,
wherein the source for the second reference signal and the source for the third reference signal are set up such that the frequency of the second reference signal is equal to the frequency of the third reference signal, and the frequency of the second and third reference signals is different from the first reference signal, and the second and the third reference signals are phase-shifted relative to each other,
with an apparatus for forming the differential signal between the output signals of the two read-out electrodes,
with an apparatus for mixing that is set up such that it mixes the output signal of the apparatus for forming the differential signal between the output signals of the two read-out electrodes with the second reference signal,
with an apparatus for mixing that is set up such that it mixes the output signal of the apparatus for forming the differential signal between the output signals of the two read-out electrodes with the third reference signal,
with an apparatus for mixing the first reference signal with the signal driving the modulator, with the result that a trigger signal is produced which has the differential frequency between the frequency of the intensity modulation of the intensity-modulated signal and the frequency of the first reference signal, and with an apparatus for the phase-locked coupling of the second and third reference signals to the trigger signal,
wherein an evaluation unit for measuring the phase position of the intensity-modulated signal is provided in signal direction behind the mixing apparatuses.

2. Device according to claim 1, **characterized in that** the differential-formation apparatuses are arranged in signal direction before the mixing apparatuses.

**3.** Device according to claim 1 or 2, **characterized in that** the phases of the second and third reference signals are phase-shifted by 90° relative to one another.

**4.** Device according to one of claims 1 to 3, **characterized in that** it has an apparatus, preferably a summation amplifier, for forming the summation signal between the output signals of the two read-out electrodes.

**5.** Device according to one of claims 1 to 4, **characterized in that** the mixer detector element is a photomixing device, preferably a PG-PMD element or an MSM-PMD element.

**6.** Device according to one of claims 1 to 5, **characterized in that** it has a source for a reference signal inverted to the first reference signal and the mixer detector element is provided with the first reference signal and also the signal inverted to it for mixing the intensity-modulated signal.

**7.** Device according to claim 1, **characterized in that** the source for the intensity-modulated signal is a source for electromagnetic radiation, preferably for radiation in the visible spectral range and particularly preferably in the infrared spectral range.

**8.** Device according to one of claims 1 to 7, **characterized in that** the differential frequency between the frequency of the intensity modulation of the intensity-modulated signal and the frequency of the first reference signal is between 1 kHz and 100 kHz, preferably between 30 kHz and 70 kHz and particularly preferably 50 kHz.

**9.** Device according to one of claims 1 to 8, **characterized in that** the mixing apparatuses embody digital circuit technology.

**10.** Device according to one of claims 1 to 9, **characterized in that** the mixing apparatuses are integrated in an IQ mixer element.

**11.** Device according to one of claims 1 to 10, **characterized in that** the mixing apparatuses are at least two difference amplifiers, wherein the supply connection of a first difference amplifier is modulated by the second reference frequency and the supply connection of a second difference amplifier is modulated by the third reference frequency.

**12.** Device according to claim 11, **characterized in that** an analog-digital converter is provided in signal direction behind the difference amplifier.

**13.** Device according to one of claims 1 to 12, **characterized in that** at least one part of the elements of the device is integrated on a chip.

**14.** Device according to one of claims 1 to 13, **characterized in that** the read-out electrodes of the mixer device element are connected to apparatuses for discharging charge carriers from the mixer detector element.

**15.** Device according to one of claims 1 to 14, **characterized in that** apparatuses are provided for uncoupling the mixer detector element from the remaining device.

**16.** Device according to claim 14 or 15, **characterized in that** the apparatuses for discharging and/or uncoupling are transistors, preferably MOS-FETs.

**17.** 3D camera with a mapping lens system and an array of devices according to one of claims 1-16.

**Revendications**

**1.** Dispositif pour détecter la position de phase de la modulation d'intensité d'un signal modulé en intensité, comportant un élément mélangeur détecteur comportant deux électrodes de lecture, l'élément mélangeur détecteur étant prévu pour mélanger le signal modulé en intensité à un premier signal de référence,
une source pour le signal modulé en intensité,
la source comportant un modulateur pour moduler l'intensité du signal à une fréquence entre 500 kHz et 500 MHz, et des sources pour des premier, deuxième et troisième signaux de référence,
la source pour le premier signal de référence étant conçue de telle sorte que la fréquence du premier signal de référence est différente de la fréquence de la modulation d'intensité,
la source pour le deuxième signal de référence et la source pour le troisième signal de référence étant conçues de telle sorte que la fréquence du deuxième signal de référence est égale à la fréquence du troisième signal de référence et la fréquence des deuxième et troisième signaux de référence est différente de la fréquence du premier signal de référence et les deuxième et troisième signaux de référence étant déphasés l'un par rapport à l'autre,
un dispositif pour former le signal de différence entre les signaux de sortie des signaux de lecture,
un dispositif pour le mélange qui est conçu de façon à mélanger le signal de sortie du dispositif pour former le signal de référence entre les signaux de sortie des deux électrodes de lecture au deuxième signal de référence,
un dispositif pour le mélange qui est conçu de façon à mélanger le signal de sortie du dispositif pour former le signal de différence entre les signaux de sortie des deux électrodes de lecture au troisième signal de référence,
un dispositif pour le mélange du premier signal de référence au signal attaquant le modulateur de sorte qu'un signal déclencheur est généré qui a la fréquence de différence entre la fréquence de la modulation d'intensité du signal modulé en intensité et la fréquence du premier signal de référence, et
un dispositif pour le couplage à verrouillage de phase des deuxième et troisième signaux de référence au signal déclencheur,
une unité d'exploitation pour déterminer la position de phase du signal modulé en intensité étant prévue en aval des dispositifs pour le mélange par référence à la direction du signal.

2. Dispositif selon la revendication 1, **caractérisé en ce que** les dispositifs pour la formation de la différence sont disposés en amont des dispositifs pour le mélange par référence à la direction du signal.

3. Dispositif selon l'une des revendications 1 ou 2, **caractérisé en ce que** les phases des deuxième et troisième signaux de référence sont déphasées de 90° l'une par rapport à l'autre.

4. Dispositif selon l'une des revendications 1 à 3, **caractérisé en ce qu'**il comporte un dispositif, de préférence un amplificateur additif, pour former le signal de somme entre les signaux de sortie des deux électrodes de lecture.

5. Dispositif selon l'une des revendications 1 à 4, **caractérisé en ce que** l'élément mélangeur détecteur est un mélangeur détecteur photonique, de préférence un élément PG-PMD ou un élément MSM-PMD.

6. Dispositif selon l'une des revendications 1 à 5, **caractérisé en ce qu'**il comporte une source pour un signal de référence inversé par rapport au premier signal de référence et l'élément mélangeur détecteur est prévu pour mélanger le signal modulé en intensité au premier signal de référence et également au signal inversé par rapport à celui-ci.

7. Dispositif selon la revendication 1, **caractérisé en ce que** la source pour le signal modulé en intensité est une source pour rayonnement électromagnétique, de préférence pour rayonnement dans la gamme spectrale visible et de façon particulièrement préférée dans la gamme spectrale infrarouge.

8. Dispositif selon l'une des revendications 1 à 7, **caractérisé en ce que** la fréquence de différence entre la fréquence de la modulation d'intensité du signal modulé en intensité et la fréquence du premier signal de référence est comprise entre 1 kHz et 100 kHz, de préférence entre 30 kHz et 70 kHz et de façon particulièrement préférée est égale à 50 kHz.

9. Dispositif selon l'une des revendications 1 à 8, **caractérisé en ce que** les dispositifs pour le mélange sont réalisés par une technique de circuits numériques.

10. Dispositif selon l'une des revendications 1 à 11, **caractérisé en ce que** les dispositifs pour le mélange sont intégrés dans un élément mélangeur IQ.

11. Dispositif selon l'une des revendications 1 à 10, **caractérisé en ce que** les dispositifs pour le mélange sont au moins deux amplificateurs différentiels, la sortie d'alimentation d'un premier amplificateur différentiel étant modulée avec la deuxième fréquence de référence et la sortie d'alimentation d'un deuxième amplificateur différentiel étant modulée avec la troisième fréquence de référence.

12. Dispositif selon la revendication 11, **caractérisé en ce qu'**un convertisseur analogique/numérique est prévu en aval de l'amplificateur différentiel par référence à la direction du signal.

13. Dispositif selon l'une des revendications 1 à 12, **caractérisé en ce que** au moins une partie des éléments du dispositif est intégrée sur une puce.

14. Dispositif selon l'une des revendications 1 à 13, **caractérisé en ce que** les électrodes de lecture de l'élément mélangeur détecteur sont reliées à des dispositifs pour la dérivation des porteurs de charges de l'élément mélangeur détecteur.

15. Dispositif selon l'une des revendications 1 à 14, **caractérisé en ce que** des dispositifs sont prévus pour le découplage de l'élément mélangeur détecteur du reste dispositif.

16. Dispositif selon la revendication 14 ou 15, **caractérisé en ce que** les dispositifs pour la dérivation et/ou le découplage sont des transistors, de préférence des MOS-FET.

17. Caméra 3D comportant une optique de reproduction et un réseau de dispositifs selon l'une des revendications 1 à 16.

**Fig. 1**

**Fig. 2**

EP 1 635 452 B1

# Fig. 3

EP 1 635 452 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19635932
- DE 19704496
- WO 0233922 A2
- DE 19902612 A1
- DE 19821974 A1
- DE 102004016624